# EUROPEAN PATENT APPLICATION

(11) **EP 3 240 003 A1**
(43) Date of publication of application: **01.11.2017**
(21) Application number: 17168302.2
(22) Date of filing: 26.04.2017
(51) Int. Cl.: H01H 23/06, H01H 9/02, H01H 9/16, H01H 9/04, H01H 23/04

(54) **SWITCH**

(30) Priority: 28.04.2016 JP 2016090915
(71) Applicant: Optex Co., Ltd., Shiga 520-0101 (JP)
(72) Inventor: SUGIMOTO, Tadashi, Shiga, Shiga 520-0101 (JP); MATSUDA, Satoshi, Shiga, Shiga 520-0101 (JP); ENDOU, Masatoshi, Tondabayashi-shi, Osaka 584-0014 (JP)
(74) Representative: Sayettat, Julien Christian

(57) **Abstract**

The present invention provides a switch which allows a communication module to be made waterproof while maintaining a switch function. A wireless switch device 1 which functions as a rocker switch includes a cover member 40 and an elastic waterproof member 20 both of which seal an opening 37 of a casing member 30 in a state in which a wireless switch module 10 is housed in the casing member 30. The wireless switch device 1 further includes a seesaw-shaped member 50 which is arranged on an outer side of the cover member 40 and the waterproof member 20 which outer side is opposite to a side on which the wireless switch module 10 is sealed with the cover member 40 and the waterproof member 20.

## Description

The present invention relates to a switch.

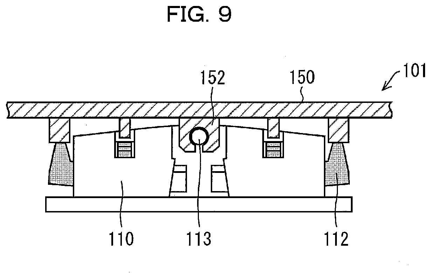

In recent years, battery-free and self-powered (energy harvesting) wireless switch devices have been developed which carry out wireless communications through electric power generated by themselves. Examples of such wireless switch devices include a device having a structure as illustrated in Fig. 9. Fig. 9 is a view illustrating the conventional technique and illustrating an example of a wireless switch device 101.

As illustrated in Fig. 9, the wireless switch device 101 is, for example, a device provided by EnOcean GmbH and includes a wireless switch module 110 and an operating section 150. The wireless switch module 110 includes power generation levers 112 and a bearing 113, and the operating section 150 includes a shaft 152.

In the wireless switch device 101, the bearing 113 is fitted with the shaft 152, and the operating section 150 is provided above the wireless switch module 110. The operating section 150 swings about the shaft 152 when a vicinity of an end part of the operating section 150 is pressed by a user, and thus presses one of the power generation levers 112 which one faces the pressed vicinity of the end part. The wireless switch module 110 generates electric power in response to a press on the one of the power generation levers 112 and carries out wireless communication through the electric power thus generated.

Meanwhile, Japanese Patent Application Publication Tokukai No. 2006-12465 (Publication date: January 12, 2006) discloses a waterproofed wireless switch device. The wireless switch device includes a piezoelectric power generation device having a piezoceramic body and a steel ball supporting elastic body which has steel balls fixed on its opposite ends. One of the steel balls is vibrated by a pressing force to the piezoelectric power generation device, and the other one of the steel balls is reciprocated (vibrated) by a resonance action. The piezoelectric power generation device generates electric power when continuous hits of the piezoceramic body by the reciprocating one of the steel balls give impact to the piezoceramic body.

For example, the wireless switch device 101 is such that, although not illustrated, another bearing 113 with which the shaft 152 of the operating section 150 is fitted is also arranged in an upper surface (top surface) of the wireless switch module 110. Further, end parts of the power generation levers 112 are located on a level lower than the upper surface of the wireless switch module 110. That is, a plurality of power generation levers 112 are provided in areas recessed from the upper surface of the wireless switch module 110. Thus, the wireless switch module 110 has a complicated structure.

Therefore, it is difficult to make waterproof the wireless switch module 110, itself, which has a complicated structure as described above, in order to achieve a wireless switch device which has a waterproof function while maintaining a switch function.

Meanwhile, the wireless switch device disclosed in Japanese Patent Application Publication Tokukai No. 2006-12465 (Publication date: January 12, 2006) is waterproofed. However, this Patent Application fails to specifically disclose what part of the wireless switch device is waterproofed.

Further, the piezoelectric power generation device having the power generation system as described above is housed in a switch case having a rectangular parallelepiped shape, wherein the power generation system of a complicated structure is provided inside the piezoelectric power generation device. Thus, even if the piezoelectric power generation device having such a simple external form is waterproofed, even a person skilled in the art cannot easily arrive at waterproofing the wireless switch module 110, itself, of the above-described complicated structure.

As a result of diligent studies, the inventors of the present invention found a structure in which a wireless switch device using a wireless switch module of a complicated structure makes the wireless switch module waterproof while maintaining its function.

The present invention has been attained in view of the above problem, and it is an object of the present invention to achieve a switch which allows a communication module to be made waterproof while maintaining a switch function.

In order to solve the above problem, a switch in accordance with an aspect of the present invention includes: an operating section including projected parts on a surface thereof opposite to an operation surface which is to be pressed by a user; a communication module including movable parts each of which is pressed by a corresponding one of the projected parts displaced when the operating section is pressed, the communication module carrying out wireless communication through electric power generated in response to a press of any of the movable parts, the movable parts being provided on two opposite lateral surfaces of the communication module, the operating section including a plate-shaped member and a middle part and pressing any of the movable parts provided on the two lateral surfaces when the middle part operates as a fulcrum, the switch further including: a casing including an opening and housing the communication module; and a sealing member which seals the opening in a state in which the communication module is housed in the casing, the sealing member including elastic parts which contacts the respective projected parts, the operating section being arranged on an outer side of the sealing member which outer side is opposite to a side on which the communication module is sealed with the sealing member.

An aspect of the present invention yields the effect of allowing a communication module to be made waterproof while maintaining a switch function.

### Brief Description of Drawings:

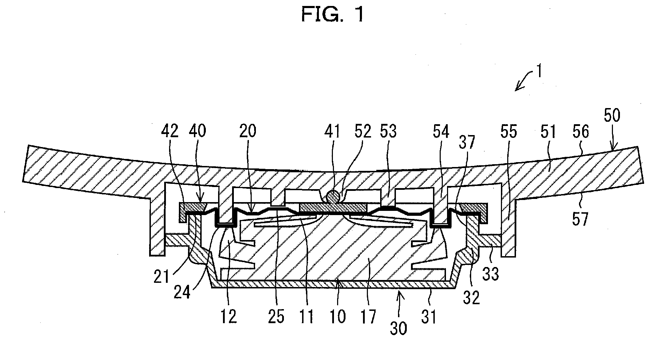

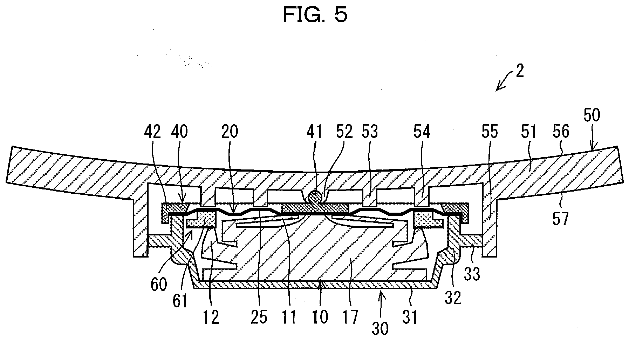

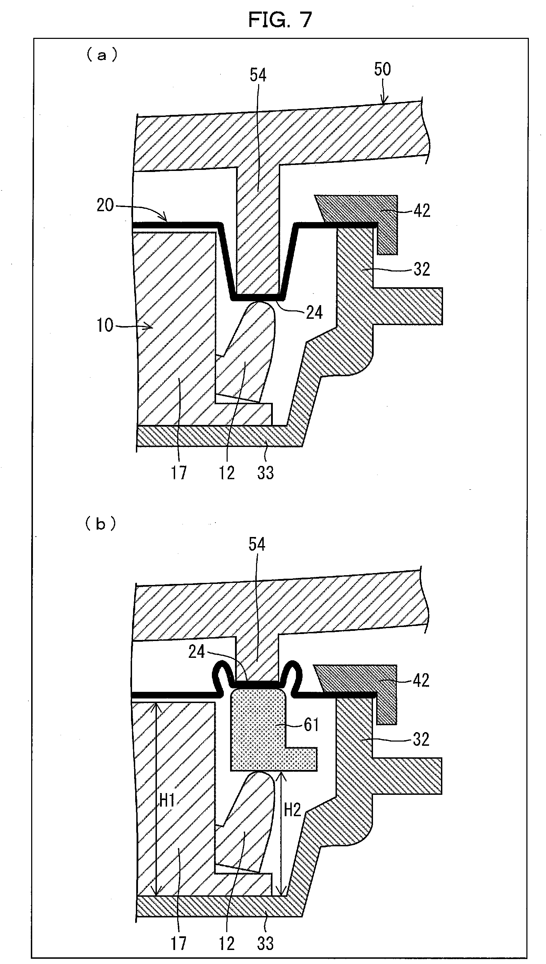

Fig. 1 is a partial cross-sectional view schematically illustrating a wireless switch device in accordance with Embodiment 1 of the present invention.
Fig. 2 is a perspective view schematically illustrating the wireless switch module illustrated in Fig. 1.
Fig. 3 is a perspective view schematically illustrating an appearance of the wireless switch device, for the sake of illustration of an operation performed by the wireless switch device illustrated in Fig. 1, wherein (a) of Fig. 3 illustrates the wireless switch device in a free state, (b) of Fig. 3 illustrates the wireless switch device in an operating state, and (c) of Fig. 3 illustrates a variation of the wireless switch device illustrated in (a) of Fig. 3.
Fig. 4 is a view schematically illustrating an internal configuration of the wireless switch device in a simplified version, for illustration of the operation of the wireless switch device illustrated in Fig. 1, wherein (a) of Fig. 4 illustrates the wireless switch device in a free state, and (b) of Fig. 4 illustrates the wireless switch device in an operating state.
Fig. 5 is a partial cross-sectional view schematically illustrating a wireless switch device in accordance with Embodiment 2 of the present invention.
Fig. 6 is a perspective view schematically illustrating an intermediate member which is provided in the wireless switch device illustrated in Fig. 5.
(a) of Fig. 7 is a partially enlarged view illustrating the wireless switch device illustrated in Fig. 1 in an operating state and illustrating an enlarged view of an area covering a pressed one of the power-generation-lever operating protruded parts and a pressed one of the power generation levers, and (b) of Fig. 7 is a partially enlarged view illustrating the wireless switch device illustrated in Fig. 5 in an operating state and illustrating an enlarged view of an area covering a pressed one of the power-generation-lever operating protruded parts and a pressed one of the power generation levers.

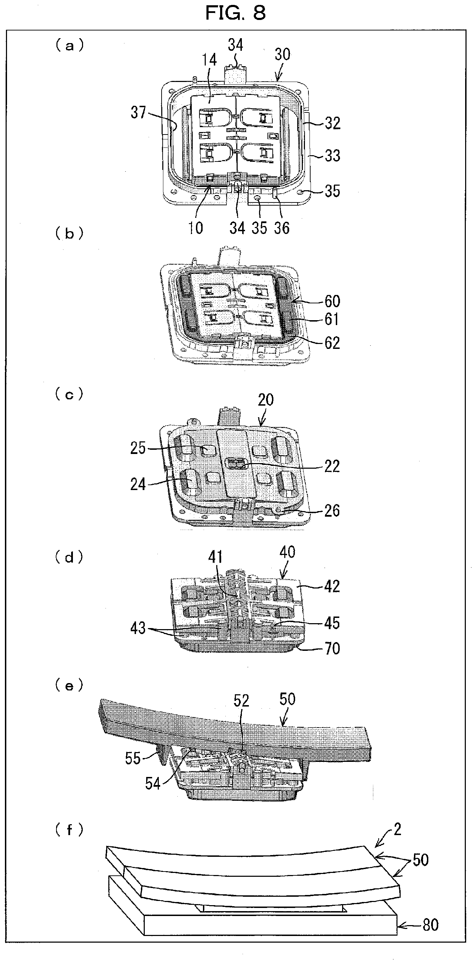

Fig. 8 is a perspective view schematically illustrating a process of assembling the wireless switch device illustrated in Fig. 5.
Fig. 9 is a view illustrating the conventional technique and illustrating an example of a wireless switch device.

In the following description, the terms "upper side" and "lower side" are defined as an operation surface side on which a user manually operates a switch device and a side opposite to the operation surface side, respectively. Further, the terms "right side" and "left side" are defined as one side corresponding to one of end parts of the operating section which the user presses in manually operating the switch device and the other side (opposite side) corresponding to the other one of the end parts of the operation section, respectively. Still further, the terms "front" and "rear" are defined as one side of the wireless switch device in a direction vertical to an up-and-down direction and a right-and-left direction and the other side of the wireless switch device, respectively. Thus, the terms "up", "down", "left", "right", "front", and "rear" in the following description do not intend to limit orientation of the switch device during a work such as assembly and installation. A front-and-rear direction is defined as a direction orthogonal to the up-and-down direction and the right-and-left direction.

The following description discusses Embodiment 1 of the present invention with reference to Figs. 1 to 4.

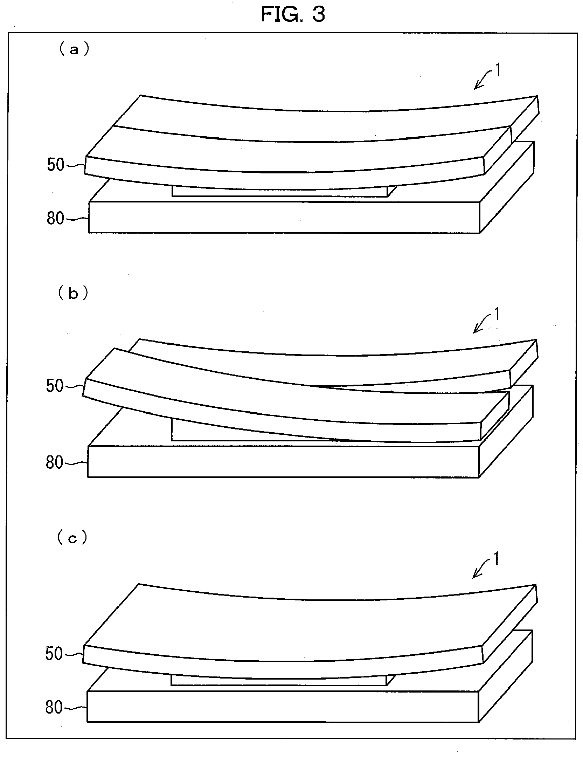

Fig. 1 is a partial cross-sectional view schematically illustrating a wireless switch device 1 in accordance with Embodiment 1 of the present invention. Fig. 1 omits an exterior 80 (illustrated in Fig. 3) included in the wireless switch device 1 and illustrates a state in which a seesaw-shaped member 50 is in a free position.

As illustrated in Fig. 1, the wireless switch device 1 includes: a wireless switch module 10 (communication module); a casing member 30 (casing) in which the wireless switch module 10 is housed; a waterproof member 20 (sealing member) with which an opening 37 of the casing member 30 is covered; a cover member 40 (sealing member) which holds the waterproof member 20 down; the seesaw-shaped member 50 (operating section), provided on the cover member 40, for operating tact buttons 11 and power generation levers 12 of the wireless switch module 10; and the exterior 80 (not illustrated in Fig. 1).

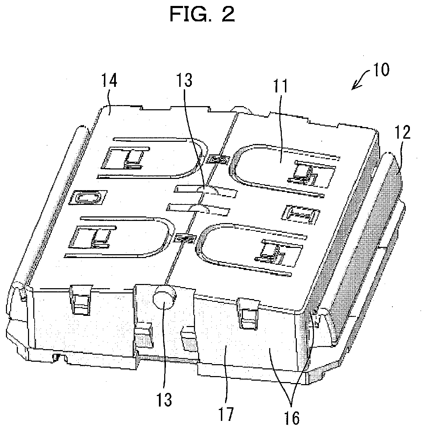

The following description discusses a configuration of the wireless switch module 10 with reference to Fig. 2. Fig. 2 is a perspective view schematically illustrating the wireless switch module 10 illustrated in Fig. 1.

As illustrated in Fig. 2, the wireless switch module 10 includes a main body 17 and power generation levers 12 (movable parts), which are provided on right and left lateral surfaces 16 (two opposite lateral surfaces) of the main body 17. The main body 17 includes tact buttons 11 arranged on an upper surface 14 of the main body 17 and also includes bearings 13 arranged in the upper surface 14 and on the other lateral surfaces 16 along a center line of the wireless switch module 10 which center line extends in the front-and-rear direction. In the main body 17, a power generation unit and a wireless communication unit (not illustrated in Fig. 2) are provided. The power generation unit generates power in response to a press of any of the power generation levers 12. The wireless communication unit carries out wireless communication by using power generated by the power generation unit.

The tact buttons 11 are switch buttons which are turned on temporarily when the tact buttons 11 are pressed so that opposed contacts are brought into contact to each other. Each of the bearings 13 is a support part which allows a shaft of a swinging member to be fitted (connected) directly with the wireless switch module 10. The tact buttons 11, the bearings 13, the power generation unit, and the wireless communication unit can be publicly known ones and thus are not detailed herein.

As illustrated in Fig. 1, the power generation levers 12 are positioned on a level lower than a level of the upper surface 14 which faces the waterproof member 20 and the cover member 40. A level of a topmost part (top end part) of each of the power generation levers 12 is lower than a level of the right and left lateral surfaces 16. The top end part of each of the power generation levers 12 is an end part thereof which faces the waterproof member 20 and is brought into contact with a power generation lever-use deformable part 24 of the waterproof member 20 when the seesaw-shaped member 50 is pressed.

The following description discusses respective configurations of the casing member 30, the waterproof member 20, and the cover member 40 with reference to Fig. 1.

The casing member 30 includes a bottom 31 on which the wireless switch module 10 is placed, a side wall 32 which stands around the bottom 31, a flange 33 which extends outward from the side wall 32, and bearings 34 (see (a) of Fig. 8) which supports the seesaw-shaped member 50 so that the seesaw-shaped member 50 is able to swing. Further, the casing member 30 has an opening 37 formed when the top end part of the side wall 32 is opened, and a topmost part of the side wall 32 is substantially on the same level as the upper surface 14 of the wireless switch module 10. The casing member 30 is made from a material having impermeability to water, and is, for example, a resin molded product.

The waterproof member 20 includes: an outer edge 21 which is located on the side wall 32 of the casing member 30; an opening 22 (see (c) of Fig. 8) which opens above the bearings 13 (see Fig. 2) which are arranged in the upper surface 14 of the main body 17 of the wireless switch module 10; power generation lever-use deformable parts 24 which are located on or above the respective power generation levers 12; and tact button-use deformable parts 25 which are located on or above the respective tact buttons 11. The power generation lever-use deformable parts 24 each extend downward so as to be shaped concavely in conformance with respective power-generation-lever operating protruded parts 54 (projected parts). That is, the waterproof member 20 includes portions which are brought into contact with the respective power-generation-lever operating protruded parts 54. Further, the tact button-use deformable parts 25 each extend upward so as to be shaped convexly. Note that the power generation lever-use deformable parts 24 and the tact button-use deformable parts 25 do not necessarily extend, provided that the power generation levers 12 and the tact buttons 11 can be pressed through the power generation lever-use deformable parts 24 and the tact button-use deformable parts 25, respectively. The waterproof member 20 can be easily and repeatedly deformed and is made from a material having elasticity and impermeability to water (e.g., rubber).

The cover member 40 includes: a bearing 41 (connecting part) which supports the seesaw-shaped member 50 so that the seesaw-shaped member 50 is able to swing; and an outer edge 42 which holds the outer edge 21 of the waterproof member 20. The cover member 40 further includes a blocking part, provided below the bearing 41, for blocking the opening 22 of the waterproof member 20. The blocking part passes through the opening 22 and is fitted (connected) with the bearings 13 which are provided in the upper surface 14 of the wireless switch module 10, so that the cover member 40 is secured to the wireless switch module 10. The bearing 41 and the outer edge 42 of the cover member 40 are firmly connected to each other in a state in which relative positions of the bearing 41 and the outer edge 42 are not changed. The cover member 40 has an opening, provided between the outer edge 42 and the blocking part, which allows the power generation lever-use deformable parts 24 and the tact button-use deformable parts 25 of the waterproof member 20 to be exposed upward. Through the opening, the power generation lever-use deformable parts 24 and the tact button-use deformable parts 25, both of which have elasticity, can be brought into contact with the power-generation-lever operating protruded parts 54 and the tact-button operating protruded parts 53, respectively, of the seesaw-shaped member 50. This allows the wireless switch device 1 to maintain its switch function. The cover member 40 is made from a material having impermeability to water and is, for example, a resin molded product.

The following description discusses a configuration of the seesaw-shaped member 50 with reference to Fig. 1.

The seesaw-shaped member 50 includes a plate-shaped main body 51 which extends in a right-and-left direction (a vertical direction with respect to the two opposite lateral surfaces 16 on which the power generation levers 12 are provided). The seesaw-shaped member 50 further includes: a shaft 52 about which the seesaw-shaped member 50 swings; the tact-button operating protruded parts 53 which press the respective tact buttons 11 of the wireless switch module 10; the power-generation-lever operating protruded parts 54 which press the respective power generation levers 12; and depression restricting protruded parts 55 which restrict excessive depression of the seesaw-shaped member 50 by a user. The plate-shaped main body 51, the shaft 52, the tact-button operating protruded parts 53, the power-generation-lever operating protruded parts 54, and the depression restricting protruded parts 55 are arranged on a lower surface 57 opposite an upper surface 56 (an operation surface which the user presses). The shaft 52 is located in a middle of the seesaw-shaped member 50 in the right-and-left direction, and an axial direction of the shaft 52 extends in the front-and-rear direction. The seesaw-shaped member 50 is made from a material that cannot be deformed so that when one end part of the seesaw-shaped member 50 is pressed, the seesaw-shaped member 50 is swung while the shaft 52 serves as a fulcrum. The seesaw-shaped member 50 is, for example, a resin molded product.

In order that the wireless switch device 1 can be easily operated by the user and has a fine design, the seesaw-shaped member 50 is shaped such that the upper surface 56 is an inwardly curved surface. With the seesaw-shaped member 50 having such a curved surface, the user can press the one end part of the seesaw-shaped member 50 with ease (i.e., with a small force) by using an action of a leverage. Since the seesaw-shaped member 50 having a curved surface (e.g., an inwardly bowed surface) which conspicuously exhibits, to the user, swinging of the seesaw-shaped member 50 and has a graceful appearance, such a seesaw-shaped member 50 is functionally and aesthetically excellent in design. If the seesaw-shaped member 50 is not considered in this point, the upper surface 56 does not necessarily have to be an inwardly curved surface.

The following description discusses waterproofing of the wireless switch module 10 with reference to Fig. 1.

The shaft 52 of the seesaw-shaped member 50 is rotatably fitted (connected) with the bearing 34 of the casing member 30 and the bearing 41 of the cover member 40. With this configuration, the seesaw-shaped member 50 does not directly contact the wireless switch module 10. Thus, the seesaw-shaped member 50 is mounted on upper sides of the waterproof member 20 and the cover member 40 (outside the casing member 30).

The cover member 40 is arranged between the waterproof member 20 and the seesaw-shaped member 50. The shaft 52 of the seesaw-shaped member 50 is supported by the bearing 41 of the cover member 40 so that the seesaw-shaped member 50 is able to swing. The tact-button operating protruded part 53 of the seesaw-shaped member 50 directly contacts the tact button-use deformable part 25 of the waterproof member 20 and is able to indirectly press the tact button 11 of the wireless switch module 10 when the seesaw-shaped member 50 is pressed. Similarly, the power-generation-lever operating protruded part 54 of the seesaw-shaped member 50 directly contacts the power generation lever-use deformable part 24 of the waterproof member 20 and is able to indirectly press the power generation lever 12 of the wireless switch module 10 when the seesaw-shaped member 50 is pressed.

Thus, the seesaw-shaped member 50 is separated from the wireless switch module 10. However, when the user presses the seesaw-shaped member 50, a switch function, a power generation function, and a wireless communication function of the wireless switch module 10 can be performed.

With the waterproof member 20, the opening 37 of the casing member 30 in which the wireless switch module 10 is housed is covered. Further, the cover member 40 is placed over the waterproof member 20 and secured to the casing member 30. This achieves, for prevention of passage of water, (i) a tight fit between the side wall 32 of the casing member 30 and the outer edge 42 of the cover member 40, wherein the outer edge 21 of the waterproof member 20 is caught between the side wall 32 and the outer edge 42 and (ii) a tight fit between the upper surface 14 of the wireless switch module 10 and the blocking part provided below the bearing 41 of the cover member 40, wherein an opening surrounding edge of the waterproof member 20 around the opening 22 is caught between the upper surface 14 of the wireless switch module 10 and the blocking part. Thus, the waterproof member 20 and the cover member 40 are used together (as sealing members) to seal the opening 37 of the casing member 30, in which the wireless switch module 10 is housed, in order to achieve imperviousness to water (that is, to prevent the passage of water through the opening 37).

As described above, the self-powered wireless switch module 10 is housed in the casing member 30 and is sealed with the waterproof member 20 and the cover member 40 both of which seal the opening 37 of the casing member 30. Further, the seesaw-shaped member 50 is arranged on an upper side of the waterproof member 20 and the cover member 40 which upper side is opposite to a side on which the wireless switch module 10 is sealed with the waterproof member 20 and the cover member 40. Therefore, the wireless switch device 1 in accordance with Embodiment 1 allows the wireless switch module 10 provided in the wireless switch device 1 to be waterproofed while maintaining a switch function of the wireless switch module 10, instead of waterproofing the whole wireless switch device 1 including the seesaw-shaped member 50.

Further, the wireless switch device 1 is capable of switch control without requiring electrical wiring. Thus, the wireless switch device 1 can be suitably used in a sophisticated place such as an office building, a hotel, and a cafe. Moreover, the wireless switch device 1 has a waterproof function. Thus, the wireless switch device 1 can be suitably used in an open-air place (e.g., an outdoor terrace) and in a sanitary space (e.g., a bathroom).

Further, the wireless switch device 1 includes: (i) the waterproof member 20 for covering the wireless switch module 10 therewith, the waterproof member 20 including the power generation lever-use deformable part 24; and (ii) the cover member 40, arranged between the waterproof member 20 and the seesaw-shaped member 50, having the bearing 41 with which the shaft 52 of the seesaw-shaped member 50 is rotatably connected. The wireless switch module 10 includes the bearing 13 with which the bearing 41 is connected, and the waterproof member 20 has the opening 22 (opening) for allowing the bearing 41 to be connected with the bearing 13. The cover member 40 seals the opening 22 therewith.

With the above configuration, the wireless switch module 10 supports the shaft 52 through the waterproof member 20 and the cover member 40. This makes it possible to seal the wireless switch module 10 even though the waterproof member 20 has the opening 22. Therefore, it is possible to waterproof the wireless switch module 10 while maintaining a swing function of the seesaw-shaped member 50 (i.e., an operation function of the seesaw-shaped member 50).

The wireless switch device 1 is configured such that the bearing 41 and the bearing 13 are connected with each other through the opening 22. This configuration makes it possible to prevent the occurrence of a phenomenon caused by a configuration in which the waterproof member 20 has no opening 22, i.e., the phenomenon in which when the seesaw-shaped member 50 is pressed, a portion of the cover member 40 near the bearing 41 (a near-center portion of the cover member 40) of the cover member 40 is upraised. Therefore, it is possible to prevent the occurrence of a situation in which the upraised near-center portion of the cover member 40 makes it hard to press the tact button 11.

The following description discusses relative positions and sizes of the opening 22 of the waterproof member 20, the bearing 41 (and the blocking part) of the cover member 40, and the bearings 13 of the wireless switch module 10.

The opening 22 of the waterproof member 20 is an opening through which the blocking part provided below the bearing 41 of the cover member 40 can be fitted with the bearings 13 provided on the upper surface 14 of the wireless switch module 10. Thus, in Embodiment 1, the opening 22 is provided at a position facing the bearings 13 of the wireless switch module 10. Specifically, the opening 22 is provided immediately above the bearings 13. In terms of waterproof property, the opening 22 is preferably as small as possible in size. Therefore, it is preferable that the size of the opening 22 is identical to that of an area where the bearings 13 are arranged or is slightly larger than that of an area where the bearings 13 are arranged.

The blocking part of the cover member 40 passes through the opening 22 and is connected with the bearings 13 of the wireless switch module 10. Thus, in Embodiment 1, the blocking part of the cover member 40, similarly to the opening 22, is provided at a position facing the bearings 13 of the wireless switch module 10. Specifically, the blocking part of the cover member 40 is provided immediately above the bearings 13. Further, the blocking part of the cover member 40 blocks the opening 22 so that water cannot pass through the opening 22. Therefore, the blocking part of the cover member 40 has a portion for holding down the opening surrounding edge of the waterproof member 20 around the opening 22. Such a portion is larger in size than the opening 22. The blocking part of the cover member 40 also has another portion for passing through the opening 22 and being connected with the bearings 13 of the wireless switch module 10. Such a portion is not larger in size than the opening 22.

It is preferable that, when viewed from above, a central rotation axis of the bearing 41 of the cover member 40 coincides with a central rotation axis of the bearing 13 of the wireless switch module 10. Therefore, it is preferable that the whole bearing 41 is also provided at a position facing the bearing 13. Specifically, it is preferable that the whole bearing 41 is provided immediately above the bearing 13.

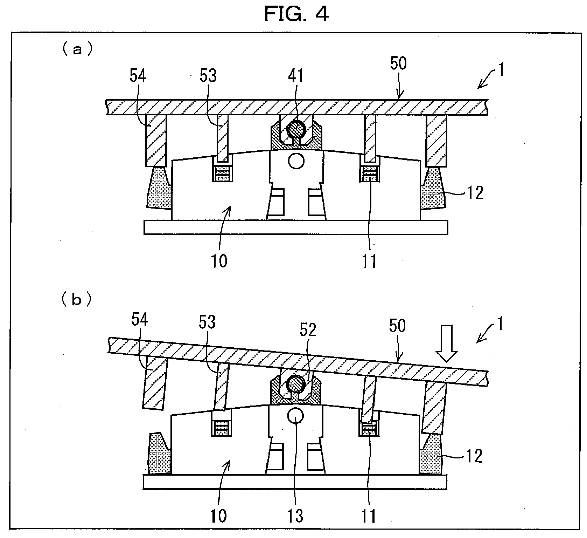

The following description discusses an operation of the wireless switch device 1 with reference to Figs. 3 and 4.

Fig. 3 is a perspective view schematically illustrating an appearance of the wireless switch device 1, for the sake of illustration of an operation performed by the wireless switch device 1 illustrated in Fig. 1. (a) of Fig. 3 illustrates the wireless switch device 1 in a free state in which the seesaw-shaped member 50 is in a free position. (b) of Fig. 3 illustrates the wireless switch device 1 in an operating state in which the seesaw-shaped member 50 is in an operating position. (c) of Fig. 3 illustrates a variation of the wireless switch device 1 illustrated in (a) of Fig. 3.

In Embodiment 1, as illustrated in Fig. 2, the wireless switch module 10 includes four tact buttons 11. As illustrated in (a) and (b) of Fig. 3, the wireless switch device 1 includes two seesaw-shaped members 50, each of which is arranged in such a manner as to be able to press the corresponding two tact buttons 11 arranged in the right-and-left direction. The four tact buttons 11 corresponds to respective given pieces of information (e.g., ON and OFF of lighting and ON and OFF of air conditioning equipment). When any of the four tact buttons 11 is pressed, an operation indicated by the corresponding information is performed. The information corresponding to the pressed tact button 11 is transmitted through wireless communication to a host device (e.g., a control device for lighting or air conditioning equipment).

Note that the seesaw-shaped member 50 is able to press the tact buttons 11 and may be formed of, for example, one plate-shaped member as illustrated in (c) of Fig. 3. In such a configuration, out of the four tact buttons 11, only two tact buttons 11 arranged in the right-and-left direction can be pressed. Thus, the seesaw-shaped member 50 includes the tact-button operating protruded parts 53 which are provided in such a manner that only the two tact buttons 11 can be pressed. That is, the configuration illustrated in (a) of Fig. 3 achieves the performance of two switch functions, whereas the configuration illustrated in (c) of Fig. 3 achieves the performance of one switch function. Further, the number of tact buttons 11 can be changed as appropriate.

As illustrated in (a) of Fig. 3, while the wireless switch device 1 is not operated by the user, that is, while any of the ends of the seesaw-shaped members 50 is not pressed by the user, the seesaw-shaped members 50 are all in free positions. As illustrated in (b) of Fig. 3, when the wireless switch device 1 is operated by the user, that is, when one (right-side or left-side) end part of one of the seesaw-shaped members 50 is pressed by the user, the seesaw-shaped member 50 thus operated by the user is swung into the operating position.

An operation performed inside the wireless switch device 1 in the above situation is discussed with reference to Fig. 4.

Fig. 4 is a view schematically illustrating a configuration of the wireless switch device 1 in a simplified version, for illustration of the operation of the wireless switch device 1 illustrated in Fig. 1. Note that Fig. 4 omits the waterproof member 20, the casing member 30, and the exterior 80, and also omits some portions of the cover member 40. (a) and (b) of Fig. 4, similarly to Fig. 3, illustrate the wireless switch device 1 in a free state and the wireless switch device 1 in an operating state, respectively.

As illustrated in (a) of Fig. 4, while the seesaw-shaped member 50 is in a free position, the tact-button operating protruded part 53 of the seesaw-shaped member 50 does not press the tact button 11 of the wireless switch module 10. Similarly, the power-generation-lever operating protruded part 54 also does not press the power generation lever 12.

As illustrated in (b) of Fig. 4, when one end part of the seesaw-shaped member 50 is pressed, the seesaw-shaped member 50 is swung while the shaft 52 serves as a fulcrum. Then, a corresponding one of the tact-button operating protruded parts 53 and a corresponding one of the power-generation-lever operating protruded parts 54 located on the side corresponding to the pressed end undergo downward displacement accordingly. The downward displacement causes the tact-button operating protruded part 53 to press a corresponding one of the tact buttons 11 of the wireless switch module 10 (while deforming a corresponding one of the tact button-use deformable parts 25 of the waterproof member 20), so that the corresponding one of the tact buttons 11 is turned on. Similarly, the power-generation-lever operating protruded part 54 also presses a corresponding one of the power generation levers 12 (while deforming a corresponding one of the power generation lever-use deformable parts 24 of the waterproof member 20), so that the power generation unit provided inside the main body 17 of the wireless switch module 10 generates power. Note that the two power generation levers 12 are configured to move in relation to each other. Thus, when one of the power-generation-lever operating protruded parts 54 presses one of the power generation levers 12, the other one of the power generation levers 12 which other one is not pressed by the other one of the power-generation-lever operating protruded parts 54 is moved downward.

Accordingly, in response to movement of the tact button 11 corresponding to the pressed one end part of the seesaw-shaped member 50 to an ON position, the wireless communication unit provided inside the main body 17 carries out wireless communication under power generated by the power generation unit. Further, the user has to press one end part of the seesaw-shaped member 50 with a relatively large amount of force so that one of the power generation levers 12 is moved downward. Thus, when the user presses one end part of the seesaw-shaped member 50, the user can experience an operational feeling which cannot be experienced by pressing the tact button 11 only.

Then, when the user moves his/her hand off the seesaw-shaped member 50, the corresponding one of the power generation levers 12 pushes up the corresponding one of the power-generation-lever operating protruded parts 54. This causes the seesaw-shaped member 50 to return to its free position and also causes the tact-button operating protruded part 53 to return to its original position before the displacement. Besides, the deformed power generation lever-use deformable part 24 and the deformed tact button-use deformable part 25 return to their original shapes due to their elasticity. Furthermore, the pressed tact button 11 is released to an OFF position.

Since the waterproof member 20 omitted in Fig. 4 is repeatedly deformable, the above-described series of movements of the seesaw-shaped member 50 and the power generation lever 12 can be made repeatedly. Further, the waterproof member 20, which is easily movable, does not impair the operational feeling experienced by the user who operates the seesaw-shaped member 50.

As described above, the wireless switch device 1 functions as a rocker switch.

The following description discusses another embodiment of the present invention with reference to Figs. 5 to 7. Note that, for convenience of explanation, identical reference numerals are given to constituent members having functions identical with those of the constituent members described in Embodiment 1, and descriptions of such constituent members are omitted here.

Fig. 5 is a partial cross-sectional view schematically illustrating a wireless switch device 2 in accordance with Embodiment 2 of the present invention. Fig. 5 omits an exterior 80 included in the wireless switch device 2 and illustrates the wireless switch device 2 in a state in which a seesaw-shaped member 50 is in a free position.

As illustrated in Fig. 5, the wireless switch device 2 includes: a wireless switch module 10; a casing member 30 in which the wireless switch module 10 is housed; a waterproof member 20 with which an opening 37 of the casing member 30 is covered; a cover member 40 which holds the waterproof member 20 down; the seesaw-shaped member 50 which operates tact buttons 11 and power generation levers 12 of the wireless switch module 10; and the exterior 80 (not illustrated in Fig. 5). The wireless switch device 2 further includes an intermediate member 60 which is provided inside the casing member 30 sealed with the waterproof member 20 and the cover member 40.

The wireless switch device 2 illustrated in Fig. 5 differs from the wireless switch device 1 illustrated in Fig. 1 in the following two points: (1) the wireless switch device 2 includes the intermediate member 60; and (2) power generation lever-use deformable parts 24 of the waterproof member 20 extend upward so as to be shaped convexly. The other points of the wireless switch device 2 illustrated in Fig. 5 are identical or equivalent to those of the wireless switch device 1 illustrated in Fig. 1.

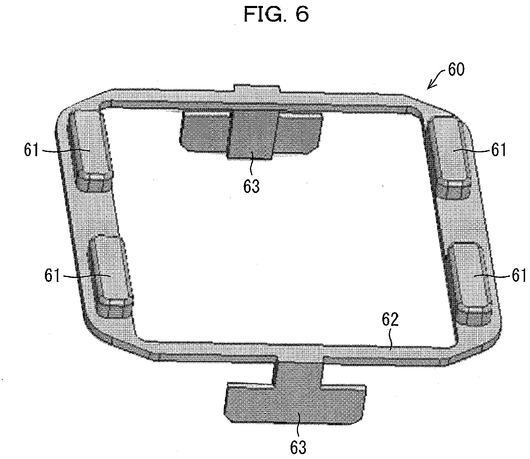

The following description discusses a configuration of the intermediate member 60 with reference to Figs. 5 and 6. Fig. 6 is a perspective view schematically illustrating the intermediate member 60 which is provided in the wireless switch device 2 illustrated in Fig. 5.

As illustrated in Fig. 6, the intermediate member 60 is arranged between the top end part of the power generation lever 12 and the waterproof member 20, and presses the power generation lever 12 in response to displacement of the power-generation-lever operating protruded part 54. The intermediate member 60 includes: intermediary protruded parts 61; a supporting surrounding part 62 (a part having a surrounding structure) for supporting the intermediary protruded parts 61 so that the intermediary protruded parts 61 are able to move; and supporting legs 63 (legs). Further, in Embodiment 2, the intermediate member 60 is shaped such that the intermediate member 60 can be provided in a gap formed by the wireless switch module 10, the casing member 30, and the waterproof member 20 and the cover member 40. For example, the intermediate member 60 is a resin molded product.

The intermediary protruded parts 61 are arranged on an upper surface of the supporting surrounding part 62 so as to correspond to the power generation levers 12 of the wireless switch module 10. The intermediary protruded parts 61 are arranged in twos each on opposite right and left sides of the supporting surrounding part 62. A height of each of the intermediary protruded parts 61 (a length of each of the intermediary protruded parts 61 in the up-and-down direction) is equal to or larger than a difference between (i) a height H1 (see Fig. 7) of each of right and left lateral surfaces 16 of the wireless switch module 10 and (ii) a height H2 (see Fig. 7) which is a level of each of the top end parts of the power generation levers 12 when each of the power generation levers 12 of the wireless switch module 10 is pressed to its lowest position (lowest point).

The supporting surrounding part 62 has a surrounding structure such that the supporting surrounding part 62 is provided between the wireless switch module 10 and the casing member 30. Specifically, the surrounding structure of the supporting surrounding part 62 is a structure whose internal shape is larger than the shape of the wireless switch module 10 when viewed from above so that the supporting surrounding part 62 can surround the margin of the wireless switch module 10, and whose external shape is smaller than the shape of the opening 37 when viewed from above so that the supporting surrounding part 62 is provided on the inner side of the side wall 32 of the casing member 30 and the wireless switch module 10. Further, the supporting surrounding part 62 is so flexible as to allow the intermediary protruded parts 61 to move upward and downward.

The supporting legs 63 extend downward from the supporting surrounding part 62 and each have a lower end portion which is so large as to stably support the intermediate member 60. Further, the supporting legs 63 are connected to the supporting surrounding part 62 at positions as far as possible from the intermediary protruded parts 61 so that a range of movement of the intermediary protruded parts 61 can be increased or so that the intermediary protruded parts 61 can be moved with a relatively small force. Moreover, the supporting legs 63 are connected to the supporting surrounding part 62 in a manner such that the supporting legs 63 are arranged symmetrically, so that the right and left sides of the supporting surrounding part 62, on which sides the intermediary protruded parts 61 are provided, are equally movable while they are kept parallel to each other in the front-and-rear direction without being twisted. Therefore, it is preferable that the supporting legs 63 are located at respective midpoints of front and rear sides of the supporting surrounding part 62, which front and rear sides are different from the right and left sides of the supporting surrounding part 62 on which sides the intermediary protruded parts 61 are arranged, and the supporting legs 63 are so arranged as to face each other.

Thus, the supporting legs 63 are connected to the supporting surrounding part 62. Besides, the supporting legs 63 maintain relative positions of the supporting surrounding part 62 and the wireless switch module 10 in a state in which the intermediate member 60 is not pressed. This makes it possible to prevent an event that may occur in the absence of the supporting legs 63, i.e., a user's unintended press of any of the power generation levers 12 due to the weight of the intermediate member 60.

Note that the configuration of the intermediate member 60 is not limited to the above-described configuration and may be any configuration, provided that the intermediate member 60 can hold the part having a height equal to or larger than the difference between the height H1 and the height H2 so that the part is able to move upward and downward.

The following description discusses an operation of the wireless switch device 2.

An operation of the wireless switch device 2 illustrated in Fig. 5 is the same as the aforementioned operation of the wireless switch device 1 illustrated in Fig. 1, except that the intermediary protruded parts 61 intermediates (i) a press of the power-generation-lever operating protruded part 54 of the seesaw-shaped member 50 on the power generation lever 12 of the wireless switch module 10 and (ii) upward movement of the power generation lever 12 to push up the power-generation-lever operating protruded part 54.

More specifically, in the wireless switch device 2 illustrated in Fig. 5, when the user presses one end part of the seesaw-shaped member 50, a corresponding one of the power-generation-lever operating protruded part 54 undergoes downward displacement. The downward displacement of the corresponding one of the power-generation-lever operating protruded parts 54 presses a corresponding one of the intermediary protruded parts 61 of the intermediate member 60 (while deforming a corresponding one of the power generation lever-use deformable parts 24 of the waterproof member 20). Then, the pressed one of the intermediary protruded parts 61 moves downward a corresponding one of the power generation levers 12 of the wireless switch module 10. When the user moves his/her hand off the seesaw-shaped member 50, the corresponding one of the power generation levers 12 pushes up the corresponding one of the intermediary protruded parts 61. The pushed one of the intermediary protruded parts 61 pushes up the corresponding one of the power-generation-lever operating protruded parts 54.

The following description discusses shape of the power generation lever-use deformable parts 24 of the waterproof member 20 with reference to Fig. 7.

Fig. 7 is a partially enlarged view illustrating each of the wireless switch devices 1 and 2 illustrated in Figs. 1 and 5, respectively, in an operating state, more specifically in a situation where one of the power generation levers 12 is in the lowest point, and illustrating an enlarged view of an area covering a pressed one of the power-generation-lever operating protruded parts 54 and a pressed one of the power generation levers 12. (a) of Fig. 7 illustrates the wireless switch device 1 illustrated in Fig. 1, and (b) of Fig. 7 illustrates the wireless switch device 2 illustrated in Fig. 5.

The wireless switch device 1 illustrated in (a) of Fig. 7 is such that no intermediary protruded part 61 of the intermediate member 60 intervenes between a corresponding one of the power generation lever-use deformable parts 24 of the waterproof member 20 and the top end part of a corresponding one of the power generation levers 12 of the wireless switch module 10. Further, the waterproof member 20 is so thin as to be able to be easily deformed repeatedly. This requires a lower end portion of a corresponding one of the power-generation-lever operating protruded parts 54 to be lowered below the upper surface 14 of the wireless switch module 10 in a state in which at least a corresponding one of the power generation levers 12 is pressed. This causes the corresponding one of the power generation lever-use deformable parts 24 of the waterproof member 20 to extend downward so as to be shaped concavely.

In this case, when at least the corresponding one of the power generation levers 12 is pressed, the power-generation-lever operating protruded part 54 is embedded below the upper surface 14 of the wireless switch module 10 (into a wireless switch module 10 side) and pushed down to the wireless switch module 10 side. This may cause a friction between the main body 17 and the corresponding one of the power generation lever-use deformable parts 24, depending on a thickness of the waterproof member 20, a material of the waterproof member 20, a degree of proximity of the main body 17 to corresponding one of the power-generation-lever operating protruded parts 54, and other factors.

Due to the occurrence of such a friction, a user who operates the wireless switch device 1 has to press one end part of the seesaw-shaped member 50 by applying a force much greater than a force applied when no friction occurs between the main body 17 and the corresponding one of the power generation lever-use deformable parts 24. Further, in a case where a friction force caused in a state in which the corresponding one of the power generation lever-use deformable parts 24 is caught between the main body 17 and the corresponding one of the power-generation-lever operating protruded parts 54 is greater than a force of the corresponding one of the power generation levers 12 to push up the corresponding one of the power-generation-lever operating protruded parts 54. As a result, even when the user moves his/her hand off the seesaw-shaped member 50, the corresponding one of the power generation levers 12 cannot sufficiently push up the corresponding one of the power-generation-lever operating protruded parts 54. This may cause a failure to return the seesaw-shaped member 50 and the corresponding one of the power generation levers 12 to their free positions before they have been pressed, and thus cause the wireless switch device 1 to be nonfunctional as a switch. The occurrence of the friction may also wear or break the waterproof member 20 and thus cause loss of the waterproof function of the wireless switch device 1.

In contrast, the wireless switch device 2 illustrated in (b) of Fig. 7 is such that a corresponding one of the intermediary protruded parts 61 of the intermediate member 60 intervenes between a corresponding one of the power generation lever-use deformable parts 24 of the waterproof member 20 and the top end part of a corresponding one of the power generation levers 12 of the wireless switch module 10. Further, a height of each of the intermediary protruded parts 61 is equal to or larger than a difference between the height H1 of each of right and left lateral surfaces 16 of the wireless switch module 10 and the height H2 which is a level of each of the top end parts of the power generation levers 12 at the lowest point. Thus, even in a state in which one of the power generation levers 12 is pressed to its lowest position, the lower end portion of the power-generation-lever operating protruded part 54 of the seesaw-shaped member 50 is on the same level as the upper surface 14 of the wireless switch module 10 or is on a level higher than the upper surface 14 of the wireless switch module 10. This eliminates the occurrence of a friction caused when one of the power generation lever-use deformable parts 24 is caught between the main body 17 and a corresponding one of the power-generation-lever operating protruded parts 54.

As described above, with the intermediate member 60 provided between the power generation levers 12 and the waterproof member 20, it is possible to prevent the occurrence of the friction as described above. This eliminates the above-described need to press the seesaw-shaped member 50 with a great force.

Further, making the height of each of the intermediary protruded parts 61 equal to or larger than the difference between the height H1 and the height H2 eliminates the occurrence of the above-described event such that the waterproof member 20 (specifically, each of the power generation lever-use deformable parts 24) is pushed down below the upper surface 14 of the main body 17. Therefore, it is possible to reliably prevent the lowering of switch operability due to the friction.

The following description discusses a process of assembling the wireless switch device 2 with reference to Fig. 8. Fig. 8 is a perspective view schematically illustrating a process of assembling the wireless switch device 2 illustrated in Fig. 5.

First, as illustrated in (a) of Fig. 8, the wireless switch module 10 is housed in the casing member 30. The flange 33 of the casing member 30 has screw through holes 35 and bosses 36. The wireless switch module 10 is placed on the bottom 31 of the casing member 30 with the upper surface 14 directed toward the opening 37 of the casing member 30 or toward the upper side.

Subsequently, as illustrated in (b) of Fig. 8, the intermediate member 60 is further housed in the casing member 30. Here, the supporting legs 63 (see Fig. 6) are provided in an upright position on the bottom 31 of the casing member 30 and are located between the front and rear lateral surfaces 16 of the wireless switch module 10 and the front and rear side walls 32 of the casing member 30. The intermediary protruded parts 61 are located above the power generation levers 12 of the wireless switch module 10.

Next, as illustrated in (c) of Fig. 8, the waterproof member 20 is so placed as to cover the opening 37 of the casing member 30. The waterproof member 20 has boss through holes 26 for positioning. When the bosses 36 of the casing member 30 are fitted into the boss through holes 26, the waterproof member 20 is properly positioned (specifically, so that the power generation lever-use deformable parts 24 are located above the power generation levers 12, the tact button-use deformable parts 25 are located above the tact buttons 11, the opening 22 is located over the bearings 13 provided in the upper surface 14 of the wireless switch module 10, and the outer edge 21 is located on the top end part of the side wall 32 of the casing member 30).

Subsequently, as illustrated in (d) of Fig. 8, the cover member 40 is placed on the waterproof member 20. The cover member 40 has screw holes 43 for screwing and boss through grooves 45. Into the boss through grooves 45, the bosses 36 of the casing member 30 are fitted. The blocking part (not illustrated) provided in a lower part of the cover member 40 blocks the opening 22 of the waterproof member 20 and is engaged with the bearing 13 of the wireless switch module 10.

Further, the casing member 30 and the cover member 40 are screwed together or secured to each other with use of screws 70 through the screw through holes 35 of the casing member 30 on the four corners and the screw holes 43 of the cover member 40 on the four corners. With the casing member 30 and the cover member 40 secured, the waterproof member 20 and the wireless switch module 10 both of which are provided between the casing member 30 and the cover member 40 are also secured. With the casing member 30 and the cover member 40 secured, the top end part of the side wall 32 of the casing member 30, the outer edge 42 and blocking part of the cover member 40, and a vicinity of the bearing 13 of the wireless switch module 10 are in intimate contact with the waterproof member 20. The intimate contact allows the wireless switch module 10 to be sealed in the casing member 30 with the waterproof member 20 and the cover member 40.

Subsequently, as illustrated in (e) of Fig. 8, one seesaw-shaped member 50 is fitted by the shaft 52 with the bearing 41 of the cover member 40 and the bearing 34 of the casing member 30. Further, the other seesaw-shaped member 50 is fitted with the bearing 41 and the bearing 34 similarly. For example, in a case where three or more seesaw-shaped members 50 are arranged in the front-and-rear direction, the seesaw-shaped members 50 located at foremost and rearmost positions are fitted with both the bearing 41 and the bearing 34, but the other seesaw-shaped member(s) 50 is fitted with the bearing 41 only.

Finally, as illustrated in (f) of Fig. 8, the exterior 80 which covers the casing member 30 is attached to the casing member 30. Here, the casing member 30, the cover member 40, and the exterior 80 are secured with use of the screws 70 through the screw through holes 35 on the both sides of the bearing 34 of the casing member 30, the screw holes 43 on the both sides of the bearing 41 of the cover member 40, and screw through holes of the exterior 80.

In Embodiments 1 and 2, the waterproof member 20 includes the opening 22 at a position facing the bearing 13 provided in the upper surface 14 of the wireless switch module 10. However, the waterproof member 20 does not necessarily have to include the opening 22. This arrangement makes it possible to bring the waterproof member 20 into intimate contact with the bearings 13 provided in the upper surface 14. This arrangement also eliminates the need to provide, below the bearing 41 of the cover member 40, the blocking part connectable with the bearing 13.

In such an arrangement, the cover member 40 and the wireless switch module 10 are not connected through the bearings 13. However, since the cover member 40 includes the bearing 41 to be connected with the shaft 52 of the seesaw-shaped member 50, the seesaw-shaped member 50 can be swung while the shaft 52 connected with the bearing 41 serves as a fulcrum.

This allows the wireless switch devices 1 and 2 to function as a rocker switch even in an arrangement in which no opening 22 is provided in the waterproof member 20, and no blocking part is provided in the cover member 40.

Configuration (1) : a switch in accordance with an aspect of the present invention includes: an operating section including projected parts on a surface thereof opposite to an operation surface which is to be pressed by a user; a communication module including movable parts each of which is pressed by a corresponding one of the projected parts displaced when the operating section is pressed, the communication module carrying out wireless communication through electric power generated in response to a press of any of the movable parts, the movable parts being provided on two opposite lateral surfaces of the communication module, the operating section including a plate-shaped member and a middle part and pressing any of the movable parts provided on the two lateral surfaces when the middle part operates as a fulcrum, the switch further including: a casing including an opening and housing the communication module; and a sealing member which seals the opening in a state in which the communication module is housed in the casing, the sealing member including elastic parts which contacts the respective projected parts, the operating section being arranged on an outer side of the sealing member which outer side is opposite to a side on which the communication module is sealed with the sealing member.

With the above configuration, the switch has the above-described movable part and operating section and thus functions as a rocker switch. In the switch which functions as a rocker switch, the self-powered communication module is sealed with the casing and the sealing member which seals an opening of the casing, and the operating section is arranged on an outer side of the sealing member which outer side is opposite to a side on which the self-powered wireless switch module is sealed with the sealing member.

This allows the communication module to be made waterproof while maintaining a function of a switch (i.e., a rocker switch).

Configuration (2): in the above configuration (1), a switch in accordance with an aspect of the present invention is preferably configured such that the movable parts have respective end parts facing the sealing member, the end parts being located at a position lower than an upper surface of the communication module which upper surface faces the sealing member, the switch further includes an intermediate member which is located between the end parts of the movable parts and the sealing member and presses the corresponding one of the movable parts when the corresponding one of the projected parts is displaced.

With the above configuration, the intermediate member is provided between the movable parts and the sealing member. This makes it possible to prevent each of the elastic parts of the sealing member from being pushed down to the communication module side by a corresponding one of the projected parts in a case where the operating section is pressed. This makes it possible to prevent the occurrence of a friction between each of the elastic parts of the sealing member and the communication module when any of the elastic parts of the sealing member is caught between a corresponding one of the projected parts and the communication module in a case where the operating section is pressed. This makes it possible to prevent the lowering of operability of a switch due to the friction (e.g., the occurrence of an event in which the operating section needs to be pressed with a larger force, an event in which even when a finger or a thumb is moved off the operating section, the operating section is not returned to its original position before the operating section has been pressed, and the like event).

Configuration (3): in the above configuration (2), a switch in accordance with an aspect of the present invention is preferably configured such that the intermediate member includes parts each of which intervenes between the corresponding one of the movable parts and the sealing member, and a height of each of the intervening parts is equal to or larger than a difference between a height of each of the lateral surfaces of the communication module and a height which is a level of each of the movable parts in a state of being pressed.

With the above configuration, it is possible to maintain the sealing member at a position that does not face any of the lateral surfaces in a case where a corresponding one of the movable parts is pressed. That is, it is possible to reliably prevent each of the elastic parts of the sealing member from being pushed down to the communication module side by a corresponding one of the protruded parts. This makes it possible to reliably prevent the lowering of operability of a switch due to the friction.

Configuration (4): in the above configuration (2) or (3), a switch in accordance with an aspect of the present invention is preferably configured such that the intermediate member further includes: a part having a surrounding structure which surrounds the communication module and is smaller in size than the opening; and legs which are connected to the part having the surrounding structure and maintaining relative positions of the part having the surrounding structure and the communication module in a state in which the intermediate member is not pressed.

With the above configuration, the intermediate member having the surrounding structure includes the legs. This makes it possible to maintain the above relative positions in a state in which the intermediate member is not pressed. Therefore, it is possible to prevent an unintended press of any of the movable parts due to the weight of the intermediate member even though the operating section is not pressed.

Further, in a case where a plurality of movable parts are present, the above configuration eliminates the need to prepare a plurality of intermediate members corresponding to the respective movable parts. Therefore, it is possible to easily produce a switch which includes the intermediate member.

Configuration (5): in any one of the configurations (1) to (4), a switch in accordance with an aspect of the present invention is preferably configured such that the sealing member includes a connecting part, provided on a surface of the sealing member which surface faces the operating section, which allows the middle part of the operating section to be rotatably connected with the connecting part.

With the above configuration, the connecting part is provided on a surface of the sealing member which surface faces the operating section. This allows the operating section to swing, regardless of structure of the sealing member.

The present invention is not limited to the embodiments, but can be altered by a skilled person in the art within the scope of the claims. An embodiment derived from a proper combination of technical means each disclosed in a different embodiment is also encompassed in the technical scope of the present invention. Further, it is possible to form a new technical feature by combining the technical means disclosed in the respective embodiments.

Reference Signs List:
1, 2 Wireless switch device (switch)
10 Wireless switch module (communication module)
12 Power generation lever (movable part)
14 Upper surface
16 Lateral surface
20 Waterproof member (sealing member)
24 Power generation lever-use deformable part (part which contacts a projected part)
30 Casing member (casing)
37 Opening
40 Cover member (sealing member)
41 Bearing (connecting part)
50 Seesaw-shaped member (operating section)
51 Main body (plate-shaped member)
52 Shaft (middle part)
54 Power-generation-lever operating protruded part (projected part)
56 Upper surface (operation surface)
57 Lower surface (surface opposite to an operation surface)
60 Intermediate member
61 Intermediary protruded part (part intervening between the movable part and the sealing member)
62 Supporting surrounding part (part having a surrounding structure)
63 Supporting leg (leg)
H1 Height of each of right and left lateral surfaces of the wireless switch module (height of each of the lateral surfaces of the communication module)
H2 Height which is a level of each of the top end parts of the power generation levers at the lowest point (height of each of the movable parts in a state of being pressed)

## Claims

1. A switch (1, 2) comprising:
an operating section (50) including projected parts (54) on a surface (57) thereof opposite to an operation surface (56) which is to be pressed by a user;
a communication module (10) including movable parts (12) each of which is pressed by a corresponding one of the projected parts (54) displaced when the operating section (50) is pressed, the communication module (10) carrying out wireless communication through electric power generated in response to a press of any of the movable parts (12), the movable parts (12) being provided on two opposite lateral surfaces (16) of the communication module (10),
the operating section (50) including a plate-shaped member (51) and a middle part (52) and pressing any of the movable parts (12) provided on the two lateral surfaces (16) when the middle part (52) operates as a fulcrum,
the switch (1, 2) further comprising:
a casing (30) including an opening (37) and housing the communication module (10); and
a sealing member (20) which seals the opening (37) in a state in which the communication module (10) is housed in the casing (30), the sealing member (20) including elastic parts (24) which contacts the respective projected parts (54),
the operating section (50) being arranged on an outer side of the sealing member (20) which outer side is opposite to a side on which the communication module (10) is sealed with the sealing member (20).

2. Switch (2) according to claim 1, wherein the movable parts (12) have respective end parts facing the sealing member (20), the end parts being located at a position lower than an upper surface (14) of the communication module (10) which upper surface (14) faces the sealing member (20),
the switch (2) further comprises an intermediate member (60) which is located between the end parts of the movable parts (12) and the sealing member (20) and presses the corresponding one of the movable parts (12) when the corresponding one of the projected parts (54) is displaced.

3. The switch (2) according to claim 2, wherein the intermediate member (60) includes parts (61) each of which intervenes between the corresponding one of the movable parts (12) and the sealing member (20), and a height of each of the intervening parts (61) is equal to or larger than a difference between a height (H1) of each of the lateral surfaces (16) of the communication module (10) and a height (H2) which is a level of each of the movable parts (12) in a state of being pressed.

4. The switch (2) according to claim 2 or 3, wherein the intermediate member (60) further includes: a part (62) having a surrounding structure which surrounds the communication module (10) and is smaller in size than the opening (37); and legs (63) which are connected to the part (62) having the surrounding structure and maintaining relative positions of the part (62) having the surrounding structure and the communication module (10) in a state in which the intermediate member (60) is not pressed.

5. The switch (1, 2) according to any one of claims 1 to 4, wherein the sealing member (20) includes a connecting part (41), provided on a surface of the sealing member (20) which surface faces the operating section (50), which allows the middle part (52) of the operating section to be rotatably connected with the connecting part (41).
